**Europäisches Patentamt**

**European Patent Office**

**Office européen des brevets**

(11) Publication number: **0 211 161**
**B1**

# EUROPEAN PATENT SPECIFICATION

(45) Date of publication of the patent specification:
28.02.90

(51) Int. Cl.⁴: **G03F 7/075**

(21) Application number: **86106714.8**

(22) Date of filing: **16.05.86**

(54) Lithographic resists and method of using the same.

(30) Priority: **31.05.85 US 739658**
**05.03.86 US 836353**

(43) Date of publication of application:
**25.02.87 Bulletin 87/9**

(45) Publication of the grant of the patent:
**28.02.90 Bulletin 90/9**

(84) Designated Contracting States:
**DE FR GB**

(56) References cited:
**DE-A- 3 322 886**
**DE-A- 3 337 303**
**GB-A- 2 154 330**

**PATENTS ABSTRACTS OF JAPAN, vol. 6,**
**no. 245 (P-159)[1123], 3rd December 1982; & JP - A**
**- 57 141 642 (FUJITSU K.K.) 02-09-1982**

(73) Proprietor: **International Business Machines**
**Corporation, Old Orchard Road, Armonk, N.Y. 10504(US)**

(72) Inventor: **Kwong, Ranee W., 31 Mina Drive, Wappings**
**Falls New York 12590(US)**
Inventor: **Sachdev, Harbans S., 14 Tanglewood Drive,**
**New York 12590(US)**
Inventor: **Sachdev, Krishna Gandhi, 14 Tanglewood**
**Drive, New York 12590(US)**

(74) Representative: **Kreidler, Eva-Maria, Dr. rer. nat.,**
**Schönaicher Strasse 220, D-7030 Böblingen(DE)**

## Description

The present invention relates to lithographic resists and methods of using the same.

Increased density of devices in integrated circuit technology requires resist materials capable of smaller image dimensions, e.g., 1 μm or less, with high sensitivity to exposure radiation including electron beams, X-rays, ultraviolet or excimer lasers, etc. High energy, shorter wavelength radiation such as deep-UV (220-290 nm), because of reduced diffraction effects, offers the possibility of high resolution imaging. Accordingly, there has developed substantial interest in the art in the use of deep-UV and an interest in designing resist materials sensitive to deep-UV radiation. Specially designed new materials for such applications are required since conventional resists are optically clear below 300 nm.

It is also well recognized that X-ray lithographic techniques have their own advantages due to negligible diffraction effects, thus providing high resolution capability, high thruput and permitting the use of relatively inexpensive tooling.

The various X-ray exposure sources useful in X-ray lithographic techniques include electron beam anode, pulsed plasma and electron storage ring emitting synchrotron radiation, the last source being known to be the most powerful source of highly collimated and intense radiation. However, the most accessible and the cheapest sources based on electron beam evaporation provide relatively weak X-ray emissions. Therefore, for practical applications of X-ray lithography in the fabrication of highly dense integrated circuit devices, the art has desired that highly sensitive resist materials be developed which also have the necessary thermal stability, resistance to dry processing (such as reactive ion etching and metal evaporation) and good adhesion to various organic and inorganic contacting surfaces to make the same useful for practical applications. Several recent reviews provide the scope and limitations of X-ray sensitive prior art resist materials:

G. N. Taylor, "X-Ray Resist Materials", Solid State Tech., 23, 73 (1980); F. Schur et al, "Electron and X-ray Irradiation of Polymers and its Application for Microlithography", Microcircuit Engineering, 82nd International Conference on Microlithography, pp. 237-253 (1982) and P. S. Burggraaff, "X-Ray Lithography: Optical's Heir", Semiconductor International, pp. 60-67 (Sept. 1983).

As is known in the art, in positive resists exposed areas generally undergo a reduction in molecular weight with a consequent increase in the solubility of the exposed areas which can be preferentially removed by solvents or dry etching with unexposed areas remaining intact. On the other hand, negative resists undergo cross-linking or other chemical changes upon exposure to various exposure radiations and become relatively resistant to removal by, e.g., solvents, in exposed areas when unexposed areas are removed.

The use of a multi-layer resist approach is known to be best suited for submicron lithography since it requires a thin imaging layer (less than about 0.5 μm) over a planarizing polymer layer of a thickness anywhere between about 1 to about 10 μm. Under these conditions, very high resolution patterns can be delineated in the thin resist layer and backscattering effects can be minimized. However, for practical applications of this approach, it is required that the imaged resist be resistant to oxygen reactive ion etching so that the pattern can be effectively transferred into the underlying polymer layer.

Various commonly known positive resists having X-ray sensitivity are subject to certain faults. For example, polymethylmethacrylate (PMMA) requires extremely high doses (1000 mJ/cm² or higher) and poly(butene sulfone), though it has higher sensitivity (94 mJ/cm²), lacks resistance to oxygen reactive ion etching.

Various approaches in the prior art for improving X-ray sensitivity have included the incorporation of heavy metals such as palladium, thallium, lead, silver, etc., or a halogen such as chlorine, bromine or iodine, in the resist formulation. From the standpoint of practical applications, both of these categories of materials are considered to be inferior since they leave non-removable residues after dry processing which can lead to device reliability problems.

Another approach for improving resist sensitivity to X-rays has been to match the emission wavelength of the exposure source to the absorption band of a particular element in the resist.

U.S. Patent 3,893,127 discloses the use of certain copolymers of sulfur dioxide and certain olefins as electron beam resists.

U.S. Patent 3,898,350 discloses positive working electron beam sensitive polyolefin sulfone resist systems based on terpolymers formed from the reaction of an olefin and hydrocarbons selected from the group consisting of cyclopentene, bicycloheptene, an acrylate monomer and sulfur dioxide.

U.S. Patent 3,961,122 discloses a method of making thin polymer films comprising a synthetic aromatic base homopolymer, a copolymer, e.g., polystyrene or polycarbonate with an organosiloxane, and a solvent. Although no disclosure occurs of resist use, it is indicated that a film of the material will cross-link when exposed to ionizing radiation.

U.S. Patent 4,267,257 discloses a method of forming a shallow surface relief pattern in a poly(olefin sulfone) layer where the sulfone is poly(3-methyl-1-cyclopentene sulfone) and a modulated beam of electrons is used, image development then being conducted with a mixture of specific solvents. These materials lack oxygen reactive ion etch resistance.

U.S. Patent 4,289,845 discloses resist compositions comprising a matrix polymer in combination with a modified polymer where, in one embodiment, the modified polymer (phase compatible blend) comprises a novolac polymer and poly(2-methylpentene-1-sulfone).

U.S. Patent 4,341,861 discloses aqueous developable poly(olefin sulfone) terpolymers useful as positive resist recording media based on 3-methylcyclopentene, 2-cyclopentene-1-acetic acid and sulfur dioxide.

U.S. Patent 4,357,369 discloses a method of forming a pattern in a substrate by oxygen plasma etching techniques utilizing as a mask a poly(silane sulfone) copolymer resist.

U.S. Patent 4,396,702 discloses a method of forming a pattern in positive resist media where the resist is based upon poly(silane sulfone) copolymers.

U.S. Patent 4,398,001 discloses resist compositions formulated by combining a novolac resin with a poly(olefin sulfone) sensitizer which is a terpolymer synthesized from sulfur dioxide, an olefinic hydrocarbon and an unsaturated ether.

U.S. Patent 4,409,317 discloses a radiation sensitive coating composition containing, as a resin component, an alkali soluble resin and poly(2-methylpentene-1-sulfone). Isoamyl acetate or a mixture of isoamyl acetate with a compatible solvent is also introduced into the resin component.

European Patent Application No. 0005775 discloses the use of certain poly(olefin sulfones) as sensitizers in substituted low molecular weight novolac resins for lithographic applications.

It is known that certain polysulfones formed by the reaction of olefins with sulfur dioxide can be employed as electron-beam resists for lithography.

Objects of the invention are radiation sensitive and at the same time oxygen reactive ion etch resistant compositions for application in integrated circuit device fabrication. A further object of the invention is a lithographic process using said resist compositions.

The objects of the invention are achieved by a resist composition and a lithographic process according to the appended claims.

Resist compositions are provided which are formulated by combining radiation sensitive polysulfones in silicon-containing resin matrices in suitable solvent systems. Thin films from these resist formulations are prepared according to standard processes involving application on desired substrates followed by a pre-bake step to remove the casting solvent.

Image-wise exposure of the dry film to radiation using conventional contact printing or projection printing techniques with an optional post-exposure bake followed by, e.g., solvent aided development of the thus post-exposure baked resist pattern provides effective and selective removal of the image-wise exposed or unexposed portions of the resist, depending on whether the resist is of the positive or negative type.

When this resist is employed in a bilayer lithographic process, the resist pattern is subsequently transferred into an underlying polymer layer by, e.g., $O_2$ reactive ion etching (RIE) when the imaging layer functions as an $O_2$ RIE mask.

The major object of the present invention is to provide novel resist compositions and processes of using the same.

Other objects of the present invention are to provide novel resist compositions which exhibit one or more of the following characteristics: they are resistant to dry processing conditions, specifically $O_2$ etching, which can be either plasma or RIE; they provide films of excellent quality with substantially no tackiness; they are highly sensitive to radiation, have good adhesion to a variety of substrates, and provide excellent resolution.

The polysulfones of the present invention are not unduly limited so long as they are thermally stable, i.e., do not undergo any significant decomposition below about 100°C and are compatible with the silicon-containing matrix resin in an appropriate solvent. Compatibility of polysulfone sensitizers in polymer blends is not a common phenomenon.

Suitable polysulfones according to this invention can be synthesized by copolymerization of olefins (linear, branched, cyclic) and/or allyl compounds with sulfur dioxide according to the general methods provided in the following references: "Polymer Synthesis", Chapter 1, Sadler and Karo, (1980); olefin polysulfone formation from a wide variety of olefins and allyl compounds is described by R.E. Cook et al in Journal of Polymer Science, Vol. XXVI, pp. 351-364 (1957); N. Takura et al in J. Polym. Sc., Part A, Vol. 1, pp. 2965-2976 (1963) and Vol. 2, pp. 3355-3363 (1964); and J. Himics et al in Polymer Engineering and Science, Vol. 17, No. 6, June 1977.

The olefinic precursors used to form the polysulfones most useful herein include straight chain or branched 1-olefins, 2-olefins, cyclic-olefins and allyl compounds. These can be represented as follows:

$$(i) \qquad CH_2 = \underset{\underset{R}{|}}{C} - R_1$$

and have a total of 4 to 12 carbon atoms, e.g., where R can be H or $CH_3$ and $R_1$ can be a linear hydrocarbon group with 2 to 10 carbon atoms, an ester group such as $COOCH_3$, or an aromatic ring such as $C_6H_5$ and $pCH_3C_6H_4$. $R_1$ can also be a branched chain alkyl group.

(ii) The cyclic-olefins for the polysulfones suitable herein include cyclopentene, 1-methylcyclopentene, 2-methylcyclopentene, cyclohexene, and bicyclo [2.2.1] hept-2-ene.

(iii) The allyl compounds most useful to form polysulfones for this application are allylethyl ether and methallyl ethyl ether.

(iv) Illustrative 2-olefins include 2-butene and 2-pentene.

These can be used singly or in combination with any of the olefins listed in (i) and (ii) to copolymerize with SO₂ to form copolymers or terpolymers.

Representative polysulfones include, e.g., poly(methylpentene-methallyl ethyl ether sulfone) synthesized by the process of U.S. Patent 4,398,001, hereby incorporated by reference, which is a terpolymer formed from the polymerization or sulfur dioxide, an olefin and an unsaturated ether, poly(2-methylpentene-1-sulfone), poly(butene-1-sulfone), poly(hexene-1-sulfone), poly(cyclopentene sulfone), poly-1-methylcyclopentene sulfone, propylene-methyl-methacrylate-SO₂ terpolymer, etc. The poly(butene-1-sulfone) is commercially available (Poly Sciences) while others can be synthesized as cited above.

The molecular weight of the polysulfones can be freely varied. They preferably have a weight average molecular weight of from about 80,000 to about 300,000.

For the matrix resin of this invention, the silicon-containing polymers are not unduly limited. Normally we use silicon-containing polymers which have a glass transition temperature (Tg) greater than about -25°C, preferably greater than about 50°C, and most preferably greater than about 100°C. The present invention should not be construed as limited to these Tg values, however. There is no maximum limitation on the Tg so long as such resins have the desired solubility in the solvent used and compatibility with the polysulfone additives so that no undesired phase separation occurs when the composite resin is applied to form thin films on various substrates.

In general, it is preferred that the silicon-containing polymers have a glass transition temperature (Tg) as high as possible (keeping the solubility consideration earlier mentioned in mind) so that there is no image deformation or flow during the optional post-exposure bake and subsequent dry processing including conventional RIE and conventional metallization steps to be later described.

The weight percent of the silicon-containing component(s) in the silicon-containing polymer preferably comprises at least about 6% as silicon, more preferably at least about 8% as silicon, by weight based on the total silicon-containing polymer. There is flexibility with respect to this particular limitation on such matrix resins in general since the desirable characteristics of the matrix resin according to this invention are that it have solubility in the solvent used, be thermally stable, and have good film forming characteristics, i.e., it not yield a tacky film and the film comprising the same be uniform. As one skilled in the art will appreciate, for a photoresist composition a further requirement for lithographic processing is that the same exhibits good adhesion to the substrate involved so that there is no adhesion failure or pattern lifting during solvent aided development of the exposed film.

Typical matrix resins useful according to this invention are alternating block polymers, block or random copolymers or terpolymers of diorganosiloxanes, silarylene siloxanes and the following non-silicon polymer segments: polycarbonate, polyester, polyurethane, polyamide, polyurea, poly(arylene ether), poly(alkylene ether), polysulfone as described in "Block Copolymers", Overview and Critical Survey, A. Noshay and J. E. McGrath, Academic Press, pp. 156-165, 392-456, (1977) and bisphenol A-polycarbonate/polydimethylsiloxane (PDMS) block copolymers containing up to 35% polydimethylsiloxane by weight as disclosed in U.S. Patents 2,999,845 (1961) and 3,189,662 (1965) and as also described by H. A. Vaughn (Polymer. lett., 7, 569 (1969)), R. P. Kambour, Block Polym. Proc. Sym., S. L. Aggarwal Ed., Plennum, NY, pp. 263-276 (1969; published 1970) and R. P. Kambour, Polymer Preprints, Am. Chem. Soc., Div. Poly. Chem., 10(2), p. 885 (1969). The composition of these resins is not unduly limited so long as the final silicon-containing polymer is resistant to plasma or O₂ RIE and the exposed pattern is developable in commonly used organic solvents or else is dry etchable in a CF₄-O₂ mixture at common plasma etching conditions to provide a residue-free surface in etched areas. Normally we prefer to use from about 10% to about 30% CF₄ in O₂, percentages being expressed as the flow rate in terms of sccm (standard cubic centimeters) of the atmosphere used.

It is contemplated that both random and block copolymers will be operable in accordance with the present invention. However, block copolymers are commercially available and are easy to synthesize according to standard procedures from commercially available starting materials.

Accordingly, as a general rule, we practice the present invention with silicon-containing block copolymers due to ease of synthesis or commercial availability.

The molecular weight of these resins can be freely varied considering the above characteristics. However, the preferred molecular weight of the silicon-containing polymers, e.g., a bisphenol A-polycarbonate/polydimethylsiloxane block copolymer, and those later described, is about 100,000 to about 200,000, weight average.

The ratio of the polysulfone and the silicon-containing polymer can be freely varied so long as the polysulfone is present in an amount effective for generation of a high contrast pattern. Preferably the polysulfone will be present in an amount of about 10 to about 30 wt% of the total polysulfone plus silicon-containing polymer.

A further benefit of the present invention is that, unlike resists based on a novolac matrix, the silicon-containing polymer matrix of the resist composition of the present invention is relatively transparent to various types of irradiation, including the deep-UV region, and thus permits one to use to full effect the sensitivity of the polysulfone to radiation, including the deep-UV region.

In addition to the above-described matrix resins such as bisphenol A-polycarbonate/PDMS block copolymers, other useful resins for the purpose of this invention are PDMS-silarylene or silphenylene copolymers (as is accepted in the art, the term "silarylene" denotes silphenylene in general including substituted silphenylene, e.g., methyl-substituted silphenylene), polystyrene-PDMS, poly-alpha-methylstyrene-PDMS copolymers, and hexamethylterephthalate-siloxane blocks. Other silicon-containing polymers suitable for the purpose of this invention are: poly(tetramethyl-p-silphenylene siloxane) (PTMPS) and its copolymers with dimethylsiloxane, i.e., PTMPS/PDMS which can be synthesized according to well known procedures as described by N. Grassie and S. R. Beattle, Polym. Degradation & Stability $\underline{7}$ (1984), pp. 109-126; R. L. Merker, M. J. Scott and G. G. Haberland, J. Polym. Sci., A2, 31 (1964) pp. 31-44; PDMS-polyethylene oxide block copolymers; and PDMS-polyurethane copolymers. Most of these resin systems are commercially available, e.g., from Petrarch Systems as listed in their "Silicon Compounds Register and Review", or can be synthesized using conventional procedures.

A preferred class of silicon-containing polymers includes poly(methylphenyl siloxanes), poly(tetramethyl-p-silphenylene siloxanes), polydimethylsiloxane-silphenylene copolymers, polydimethylsiloxane-alpha-methylstyrene copolymers, bisphenol A-polycarbonate-polydimethylsiloxane block copolymers, polydimethylsiloxane-styrene block copolymers, hexamethylterephthalate-siloxane block copolymers and polyurethane-siloxane block copolymers.

A preferred class of silicon-containing block copolymers includes those where the silicon-containing segments are polysilphenylenesiloxanes, polydialkylsiloxanes, polysilarylene siloxanes, and dimethylsiloxane, combined with non-silicon-containing segments from bisphenol-A-polycarbonate, polyurethane, polyester, polyimide, polyurea, poly(alkylene ether) and polysulfone.

As will be seen from the above exemplification of silarylene or siloxane-containing copolymers, e.g., poly(tetramethylsilphenylene) siloxane and silarylene-siloxane/dimethylsiloxane copolymers, it is possible for both the segments or blocks in the polymer structure to contain silicon. We generally prefer, however, that there be a minimum of about 8 wt% of silicon content in the final homopolymer, copolymer or terpolymer, be it from, e.g., a polydimethylsiloxane segment or an alternative structural unit, this figure, however, not being limited so long as the Tg of the silicon-containing resin is not excessively low. Increasing amounts of silicon as, e.g., dimethysiloxane moiety, tend to lower the Tg and, as earlier indicated, an excessively low Tg will tend to result in image deformation (flow) during the optional post-exposure bake and RIE processing. As a consequence, we would not generally expect to use silicon-containing polymers with more than about a 60 wt% silicon content as silicon.

The resin formulations per the present invention are formed by dissolving the polysulfone(s) in a solution of the matrix resin prepared by predissolving the matrix resin in a solvent or a solvent mixture. Usually the resin components are dissolved at ambient temperature, though we see no reason why higher temperatures could not be used so long as the recognized sensitivity of polysulfones to heat does not become a problem. We see no advantage to using such higher temperatures at present. The solvents are not limited and are typically organic solvents or mixtures thereof. Representative examples include chlorobenzene, toluene, isoamyl acetate, cyclohexanone, and dichloromethane (too low boiling point to be preferred). Obviously other solvents that will provide a homogeneous coating formulation of the polysulfone and silicon-containing resin can be used.

The concentration of the polysulfone and the silicon-containing resin in the solvent are selected so as to obtain a mutually compatible resist formulation and the concentration is not limited. We have found that the total solids content can preferably vary from about 4 to about 10 wt% polysulfone and the matrix resin (based on solvent weight) to be convenient for film deposition by spin coating, spray application.

All components are, of course, well mixed into the solvent, but there is no criticality to the mixing procedure.

Normally the coating formulations are filtered through a submicron filter prior to use to remove particulates or polymer gels which can be the source of film defects. This is a conventional step in the art. We normally use a 0.2 μm silver membrane (commercially available) to remove such particulates.

The dry thickness of the resist films per the present invention is not limited in any substantial fashion so long as the resist films are free of defects including pinholes and are optimum for processes requiring pattern transfer into underlying films having a, e.g., about a 1-5 μm thickness. We have found that thicknesses on the order of about 200 nm to about 800 nm provide excellent results, e.g., for pattern generation by radiation such as deep-UV lithography and subsequent image transfer into the base layer by $O_2$ RIE.

The resist composition of the present invention can be applied onto any desired substrate in a conventional manner, e.g., spinning, dipping, spraying. Currently we prefer to use a conventional spin application.

Examples of the substrates for the resist process of the present invention include a variety of surfaces as are used in the fabrication of microelectronic devices, e.g., silicon, silicon oxide, silicon nitride, deposited according to conventional methods such as plasma, low pressure chemical vapor deposition (LPCVD) and plasma-enhanced chemical vapor deposition (PECVD). For application of the resist of this invention in bilayer lithographic processes, thicker underlayers formed from polymer coating compositions are employed and subjected to any desired or necessary conventional high temperature bake prior to overcoating with the resist formulation of the present invention. The conventional materials for the underlayer typically include materials such as Shipley AZ-1350J, ICI polysulfone, soluble polyimides, typically those available from Ciba Geigy such as XU-218, and from General Electric Corp., such as GE ULTEM polyetherimide, which can withstand metal evaporation temperatures. Conventional photoresists are often used as such an underlayer which is baked at temperatures higher than 200°C to render the film insensitive to optical or the image-wise exposure radiation used, e.g., UV radiation. Thus, in the present invention the term substrate is not limited to conventional inorganic substrates, but includes polymer surfaces for application of the resist composition of the present invention.

One application where the resist composition of the present invention is particularly useful is in a bilayer resist system where the resist composition of the present invention functions as an $O_2$ etch resistant imaging layer and the conventional polymer underlayer as above-discussed is for image transfer through dry or wet processing so as to obtain a desired image depth and also functions as a lift-off layer for conventional metal lift-off processing. Such will now be described. For brevity, the pre-bake, image-wise exposure and optional post-bake of the present invention are not discussed in detail. These would, of course, actually be used. The conventional polymer underlayer, in a bilayer resist system, would generally be one amenable to oxygen etching, either plasma or RIE. It is not, of course, mandatory that the resist composition be used in a bilayer resist process and it can be employed in a single layer process or for mask making.

Normally when we process in a bilayer resist system involving the resist composition of the present invention over a conventional underlayer, the latter is generally baked up to 200°C to 270°C prior to applying the resin composition. This temperature is not limitative and the ambient of baking is not important, e.g., is typically air for a lower temperature (less than 100°C) while for a higher temperature such as 200°C to 270°C, an inert gas is employed. For example, Shipley AZ-1350J can be applied by spin coating in a conventional manner and then baked up to 230°C in, e.g., $N_2$. The time of baking is merely selected to insure that the earlier mentioned insensitivity is obtained.

Thus, in a typical procedure, the underlayer is first spin applied on the desired substrate, baked at 85°C for 20 minutes followed by 200°C($N_2$) for 15 minutes and 230°C ($N_2$) for 30 minutes. The resist composition of the present invention is applied and the film baked (pre-bake) at about 85-115°C for about 20-40 minutes and contact printed in a conventional manner using an appropriate exposure device, e.g., a Kasper UV exposure device for deep-UV. After the exposure, e.g., deep-UV exposure, the film is subjected to an optional but preferred post-bake at about 80-110°C for about 10-30 minutes, typically 105°C for 15-30 minutes, whereupon high resolution relief images are obtained. Subsequent solvent development is followed by $O_2$ plasma etching or RIE to transfer the fully developed pattern into the underlayer when the top layer functions as an $O_2$ etch mask. Replication of the resist pattern into the underlayer is followed by metallization in a conventional manner, e.g., sputtering or vacuum evaporation, after standard premetallization cleaning steps. Lift-off is then accomplished in a conventional manner by, e.g., a solvent soak, to obtain the image-wise metal pattern for an integrated circuit device.

The above aspect of the present invention is quite beneficial on a commercial basis since X-ray and electron beam sensitive positive or negative resists and positive deep-UV resists with high sensitivity and resolution having the necessary $O_2$ etch resistance for dry processing have been essentially non-existent prior to the present invention.

By the term deep-UV radiation herein we mean ultraviolet radiation in the range of about 200 to about 300 nm, more typically about 200 to about 290 nm with commonly available commercial exposure devices. The resist films according to this invention are also imageable by an excimer laser, e.g., 248 nm radiation.

No matter what radiation is used in the image-wise exposure of the present invention, exposure times/intensities can be optionally selected so long as the polysulfone is activated to provide the desired difference in removal characteristics between exposed and unexposed areas. For a positive resist, substantial cross-linking in the irradiated areas of the resist should be avoided, as will be apparent to one skilled in the art, i.e., cross-linking which would excessively inhibit removal of exposed resist areas. Further, as will also be apparent to one skilled in the art, usually greater resist thicknesses require greater exposure times and/or intensities, with the reverse being the case with lesser resist thicknesses. While not limitative, we have usually used exposure times of about 10 to about 90 seconds with an average exposure dose of about 10 to about 200 millijoules per square centimeter.

These resist materials also have high sensitivity to X-rays and electron beams and thus can be used for pattern generation with these techniques for lithographic processing.

This high sensitivity coupled with oxygen reactive ion etch resistance renders the resist compositions of the present invention particularly suited for single layer or bilayer resist processes to provide high resolution metal patterns.

Additionally, we have found that using conventional X-ray sources, e.g., 0.834 nm wavelength, the resist films of the present invention can be employed to generate either positive or negative patterns by varying the exposure dose. For example, less than 0.5 μm thick resist films of bisphenol A-polycarbonate-polydimethylsiloxane block copolymer having 20% (by weight) of poly(methylpentene-methallyl ethyl ether sulfone) upon exposure to an aluminum $K_\alpha$ X-ray source at 20-30 mJ/cm² followed by a brief post exposure bake and solvent development provide positive patterns. The brief post bake is a preferred but not essential step. The same films, when exposed to 120 mJ/cm² or a higher dose followed by development, provide negative patterns.

Resist films per the present invention have also been found to be imageable by electron beam exposure with very high resolution at relatively low doses. Less than 0.5 µm films, when subjected to electron beam exposure at 1.0 µC/cm² to 5 µC/cm² followed by a brief post exposure bake at, e.g., 85-105°C, provided positive relief patterns with resolution down to 0.25 µm lines. Subsequent image development by suitable solvent(s) or dry etching techniques can be used for complete image development. The same films, when exposed to a dosage ranging between about 10.0 µC/cm² and about 15.0 µC/cm² or a higher dosage, followed by development, provide negative patterns.

Since the resist patterns, be they positive or negative, generated with these resist systems of the present invention are resistant to oxygen reactive ion etching, the image can be transferred into an underlayer, which is generally organic, by dry processing during which the imaged resist acts as a mask.

By X-ray or electron beam irradiation we mean X-ray or electron beam irradiation as is conventionally used in the art for resist exposure from any conventional source. Depending upon the X-ray or electron beam intensity, the resist of the present invention will exhibit either negative or positive characteristics. At high X-ray or electron beam exposure doses, the resist of the present invention will exhibit negative characteristics whereas at low exposure doses the resist of the present invention will exhibit positive characteristics. Normally times can be freely varied, and typically we use exposure times on the order of about 10 to about 90 seconds.

With X-rays, to date we believe the best results will be achieved using an average exposure dose of from about 10 to about 50 millijoules per square centimeter to achieve positive resist characteristics whereas best results will be achieved at an average exposure dose greater than about 120 millijoules per square centimeter to achieve negative resist characteristics. To achieve negative resist characteristics, usually we do not prefer to use an average exposure dose greater than about 200 millijoules per square centimeter since we believe that at very high exposure doses, e.g., at about 300 millijoules per square centimeter, the amount of stray irradiation will cause cross-linking in areas where cross-linking is not desired.

As will be apparent to one skilled in the art, the above exposure dose ranges of about 10 to about 50 millijoules per square centimeter to achieve positive resist characteristics and greater than about 120 millijoules per square centimeter up to about 200 millijoules per square centimeter are not absolute, i.e., between about 50 millijoules per square centimeter and about 200 millijoules per square centimeter there will be a gradual blending between negative and positive resist characteristics. Since we generally desire to obtain about a 70 to about a 80 wt% retention of resist in areas where resist is to remain, we most prefer, at present, to practice within the above ranges. Obviously, the higher the amount of resist retention, the better. As one strays further and further above about 50 millijoules per square centimeter or below about 120 millijoules per square centimeter the percent resist retention decreases; if one practicing the present invention could accept a lower resist retention in areas where resist is to remain, practice outside the above ranges would be possible. For the precise applications we generally contemplate, however, the above exposure dose ranges provide best results.

The above discussion has been regarding X-ray irradiation, but we believe the principles described apply with equal force to electron beam as well. The exception is that for electron beam irradiation, the dosage ranges for positive working resists range between about 1.0µC/cm² and about 5µC/cm², and the dosage ranges for negative working resists range between about 10.0µC/cm² and about 15.0µC/cm² for good results. Higher dosages can be used for the negative working resists, but we see no advantage at this time to using higher dosages.

As a general rule, we have found that better resolution and superior resist performance results using post-exposure baking. We believe that during image-wise exposure, e.g., to deep-UV radiation when a positive resist is involved, radicals are generated in exposed areas which remain until the time of post-baking and, if post-baking is conducted, superior radical degradation is achieved in exposed areas, volatile species are created which are removed in the post-baking and porosity in exposed areas will be increased to render solvent permeation into the exposed areas more efficient, whereby accelerated solvent-aided image development is obtained. For thicknesses as earlier exemplified, a post-exposure bake at up to about 80-110°C for about 10-30 minutes provides excellent results. The atmosphere of the post-exposure bake is not important and, to date, we have merely heated in air on a hot plate. Thus, while optional, the use of a post-exposure bake is highly preferred.

For complete pattern delineation, normally we use a dry development technique such as plasma etching in $CF_4$-$O_2$ or, more preferably, use a solventaided development in a conventional manner, generally following exposure/post-bake. While most of our experience has been with solvent-aided development, we believe that both solvent-aided development and $CF_4$-$O_2$ plasma etching will provide fully developed submicron patterns with a high aspect ratio.

Currently preferred solvent mixtures for development of deep-UV sensitive resists include 30 vol% isoamyl acetate in isopropanol (30 ml isoamyl acetate/70 ml isopropanol), with which we have had best results, or similar proportions of tetrahydrofuran in isopropanol or similar proportions of dichloromethane in hexane. Currently preferred solvent mixtures for development of X-ray and electron beam sensitive resists include hexane-acetone-ethylacetate which optionally may have a small amount of methylisobutyl ketone acid. Currently most preferred proportions are given in Examples 3 to 5, though as is the case with the deep-UV sensitive resists, other proportions can be used. Often the minor component(s) in an amount of about 20 to about 30 vol% based on the total solvent volume present seems to provide very good results. Any solvent systems can be used which would, of course, selectively dissolve unexposed or exposed areas without excessively removing exposed or unexposed areas, and as earlier indicated, we currently prefer that no more than about 20 to about 30% of the exposed or unexposed areas be removed, depending upon whether the resist exhibits positive or negative characteristics. As will be apparent to one skilled in the art, some removal of unexposed areas would be acceptable for most purposes.

Usually we practice solvent-aided development at ambient; development according to the present invention can be aided by mild ultrasonic agitation so as to assist in resist removal in exposed areas, if desired.

Having thus described generally preferred embodiments of the present invention, the following working Examples are offered to provide a currently preferred best modes of practicing the invention.

Example 1

A solution of a positive resist composition per the present invention (6 wt% total solids based on solution weight) was formed by dissolving, at a weight ratio of 4:1, a bisphenol A-polycarbonate-polydimethylsiloxane block copolymer (weight average molecular weight of about 150,000, Tg of about 160°C, about 35% of polydimethylsiloxane by weight of the copolymer) and poly(methylpentene-methallyl ethyl ether sulfone) ($\overline{Mw}$ 200,000) in chlorobenzene at ambient temperature.

The above solution was filtered through a 0.2 µm filter. It was then spin-applied in a conventional manner onto a 2.1 µm thick layer of Shipley AZ-1350J (which had been baked at 230°C in $N_2$) coated on a silicon substrate.

Following the above application, the assembly was subjected to a pre-baking at 105°C for 30 minutes in nitrogen to provide a resist assembly (resist composition per the present invention and the Shipley 1350J base layer) having a total thickness of about 2.4 µm.

Image-wise exposure was then conducted with deep-UV for 45 seconds through a contact mask using a conventional Kasper deep-UV exposure system (ca. 45 sec. and 100 millijoules/$cm^2$).

Following image-wise exposure, the assembly was post-baked at 105°C for 30 minutes in air, providing a very clear relief pattern in the resist composition of the present invention.

After the above post-bake, the assembly was submerged in a solution containing 30% of isoamyl acetate in isopropanol for 3 minutes at room temperature to provide a fully developed positive pattern in the resist composition of the present invention. A brief heat treatment was then employed to evaporate any retained solvent in the film and the pattern was transferred into the underlying Shipley AZ-1350J layer down to the substrate using a conventional $O_2$ RIE process at 250-300 watts with 25 sccm oxygen flow.

The fully etched images had a final thickness of about 2.3 µm, demonstrating that the resist composition layer per the present invention remained intact during $O_2$ RIE and permitted transfer of the image into the Shipley AZ-1350 base layer.

Example 2

A 50 wt% xylene solution of polydimethylsiloxane-alpha-methylstyrene block copolymer $\overline{Mw}$ 80,000-120,000) obtained from Petrarch Systems was diluted with toluene to form about a 10 wt% resin solution based on resin solids. To 200 g of this solution was added 2.5 g of poly(methylpentene-methallyl ethyl ether sulfone) - $\overline{Mw}$ same as in Example 1, formed per U. S. Patent 4,398,001 - to form a clear solution of a positive resist which was filtered per Example 1 and spin applied on silicon wafers to a thickness similar to that in Example 1, pre-baked in nitrogen at 105°C for 30 minutes and exposed to deep-UV as in Example 1 through a contact mask. When the exposed film was subjected to a post-bake at 105°C for 10-15 minutes in air, a high resolution relief pattern appeared which was developed down to the substrate by a brief dip in an isoamyl acetate-isopropanol mixture (30:70 parts by volume).

A similar resin formulation prepared by mixing the poly(methylpentene-methallyl ethyl ether sulfone) with a similar toluene solution of poly(tetramethylsilphenylene siloxane), $\overline{Mw}$ 150,000 (Petrarch Systems), as the resin system, was processed according to the procedure described above to provide an excellent quality resist pattern. When used in a bilayer process, the resist image could be transferred into the underlayer by $O_2$ RIE with the image layer functioning as an effective $O_2$ RIE mask.

Example 3

The filtered resist composition prepared as a solution in chlorobenzene described in Example 1 was spin applied on a silicon substrate and pre-baked at 105°C for 30 minutes in nitrogen to form about a 420 nm thick film (dry thickness). X-ray exposure was conducted using a conventional aluminum $K_\alpha$ X-ray

source at 20-30 mJ/cm$^2$ followed by a 10 minute post-bake at 85°C in air. A clear relief pattern was visible. A subsequent soak for 1 minute at ambient in a mixed solvent system consisting of hexane-acetone-ethylacetate in the ratio 6:1:1 (volume), respectively, followed by a hexane rinse gave a fully developed positive pattern when the exposed area was preferentially removed. A brief post development bake (10 minutes) at 85°C in air to remove the trapped solvent gave the remaining thickness of 320-340 nm with about a 20% loss of the unexposed area during removal of the exposed area.

The process was repeated in a bilayer resist system using hard baked AZ 1350 photoresist as a thick underlayer following the procedure of Example 1. The exposed and developed pattern (same as above) was post-baked as above and etch transferred into the bottom layer by O$_2$ RIE at 25 sccm gas flow, 0.05 μ bar gas pressure and 300 Watts RF power. Under these conditions the patterned resist provided an effective O$_2$ RIE mask.

Example 4

The filtered resist composition described in Example 1 was spin applied on silicon wafers as per Example 1 and pre-baked at 105°C for 30 minutes in nitrogen to form about a 420 nm thick film. X-ray exposure using the same conventional exposure source as in Example 3 at 120-150 mJ/cm$^2$ followed by a post-bake at 80°C for 10 minutes in air showed a clear relief pattern. A subsequent solvent soak for 2-3 minutes in hexane-acetone-ethyl acetate in the same ratio as in Example 3, but additionally having a small amount of methylisobutyl ketone (about 5 vol% of the total mixture), gave a fully developed negative pattern with about 2500 Å thickness remaining. This was subjected to a post development bake in air at 90°C for 15 minutes to remove trapped solvent. The pattern had excellent dry etch resistance to O$_2$ RIE and thus could be used as a RIE mask in a bilayer resin process.

Example 5

About 0.4 μm thick films of the resist materials of Examples 3 and 4, pre-baked, etc., were spin applied as in those Examples, on silicon wafers and were exposed then to an electron beam direct write at 2.5 μC/cm$^2$ and 5 μC/cm$^2$. A post exposure bake at 90°C for 15 minutes in air showed high resolution relief patterns with submicron resolution down to 0.125 μm lines. Microscopic examination showed excellent quality and sharp image definition up to 0.25 lines in a line and space array. Thickness measurement of the exposed and unexposed regions of the patterned resist showed that the exposed area had undergone a decrease in thickness relative to the unexposed area and thus a positive pattern was obtained at this low electron beam dose.

A subsequent solvent soak as in Example 3 or a conventional plasma development was used to provide fully developed patterns. The process was repeated in a bilayer scheme as described above for generating high resolution patterns in a relatively thick underlayer when the electron beam resist pattern provides the necessary O$_2$ RIE resistant mask.

While there has been described what are at present considered to be the preferred embodiments of this invention, it will be obvious to those skilled in the art that various changes and modifications may be made therein without departing from the invention.

**Claims**

1. Lithographic resist comprising a mixture of at least one radiation sensitive polysulfone with at least one silicon-containing polymer.

2. Resist of claim 1, wherein the polysulfone is a copolymer formed from the polymerization of sulfur dioxide with a material selected from the group consisting of straight chain 1-olefins, branched 1-olefins, 2-olefins, cyclic olefins and allyl compounds.

3. Resist of claim 2, wherein the polysulfone copolymer is selected from the group consisting of poly(2-methylpentene-1-sulfone), poly(butene-1-sulfone), poly(hexene-1-sulfone), poly(cyclopentene-sulfone) and mixtures thereof.

4. Resist of claim 1, wherein the polysulfone is a terpolymer formed from the polymerization of sulfur dioxide, an olefin hydrocarbon and an unsaturated ether.

5. Resist of claim 4, wherein the polysulfone is poly(methylpentene-methallyl ethyl ether sulfone).

6. Resist of claim 1, wherein the at least one silicon-containing polymer is selected from the group consisting of homopolymers, copolymers, terpolymers and mixtures thereof.

7. Resist of claim 6, wherein the homopolymer, copolymer or terpolymer is comprised of polymeric materials selected from the group consisting of poly(methylphenyl siloxanes), poly(tetramethyl-p-silphenylene siloxanes), polydimethylsiloxane-silphenylene copolymers, polydimethylsiloxane-alpha-methylstyrene copolymers, bisphenol A-polycarbonate-polydimethylsiloxane block copolymers, polydimethylsiloxane-styrene block copolymers, hexamethylterephthalate-siloxane block copolymers and polyurethane-siloxane block copolymers.

8. Resist of claim 6, wherein the silicon-containing copolymer is a block copolymer comprising silicon-containing segments selected from the group consisting of polysilphenylene-siloxane, polydialkylsiloxanes, polysilarylene siloxanes, and dimethylsiloxane, combined with non-silicon-containing segments selected from the group consisting of bisphenol-A-polycarbonate, polyurethane, polyester, polyimide, polyurea, poly(alkylene ether) and polysulfone.

9. Resist of claims 1 and 8, comprising a mixture of bisphenol-A-polycarbonate-polydimethylsiloxane block copolymer with poly(methylpentene-methallyl ethyl ether sulfone).

10. Resist of claims 1 and 8, comprising a mixture of polydimethylsiloxane-alpha-methylstyrene block copolymer with poly(methylpentene-methallyl ethyl ether sulfone).

11. Lithographic process which comprises coating the resist compositions of one or several of claims 1 to 10 on a substrate, baking the resist, image-wise exposing with radiation, and developing to remove exposed or unexposed image portions of the resist to result in a resist pattern.

12. Process of Claim 11, wherein following the image-wise exposing with radiation, the exposed resist is subject to a post-baking at a temperature of about 85 to about 115°C for about 20 to about 40 minutes preferably at about 80°C to about 110°C for about 10 to about 30 minutes.

13. Process of claim 11, wherein the image-wise exposing is with deep ultraviolet radiation at a wavelength of about 200 to 300 nm.

14. Process of claim 11, wherein the image-wise exposing is with X-ray irradiation with an average exposure dose of about 10 to about 50 millijoules per square centimeter for positive resist characteristics, or with an average exposure dose of about 120 to about 200 millijoules per square centimeter for negative resist characteristics.

15. Process of claim 11, wherein the image-wise exposing is with electron beam irradiation with an average exposure dose of about 1.0 to about 5.0 micro coulombs per square centimeters for positive resist characteristics, or with an average exposure dose ranging from about 10.0 micro coulombs per square centimeter to about 15.0 micro coulombs per square centimeter for negative resist characteristics.

16. Lithographic process of claim 11 which further includes transferring of the resist pattern by etching, preferably by plasma or reactive ion etching, into a polymeric underlayer.

17. Lithographic process of claim 16, where a metal is further deposited after completely removing the exposed image portions of the resist and said metal along with the underlying polymer is removed in the unexposed areas where resist is present by a solvent lift-off procedure.

18. Lithographic process which comprises film deposition of the resist compositions of one or several of claims 1 to 10 on a substrate followed by a prebake, image-wise exposure with an excimer laser to deep-UV radiation, and solvent or dry developing to completely remove the exposed image portions of the resist.

## Patentansprüche

1. Lithographischer Resist bestehend aus einer Mischung von wenigstens einem strahlungsempfindlichen Polysulfon mit mindestens einem siliciumhaltigen Polymer.

2. Resist nach Anspruch 1, bei dem das Polysulfon ein Copolymer ist, das durch Polymerisation von Schwefeldioxid mit einem Material der Gruppe geradkettiger 1-Olefine, verzweigter 1-Olefine, 2-Olefine, zyklischer Olefine und Allylverbindungen gebildet wird.

3. Resist nach Anspruch 2, bei dem das Polysulfoncopolymer aus der Gruppe von Poly(2-methylpenten-1-sulfon), Poly(buten-1-sulfon), Poly(hexen-1-sulfon), Poly(cyclopenten-sulfon) und deren Mischungen gebildet wird.

4. Resist nach Anspruch 1, bei dem das Polysulfon ein Terpolymer ist, das durch Polymerisation von Schwefeldioxid, einem olefinischen Kohlenwasserstoff und einem ungesättigtem Ether gebildet wird.

5. Resist nach Anspruch 4, bei dem das Polysulfon ein Poly(methylpenten-methallyl-ethylether-sulfon) ist.

6. Resist nach Anspruch 1, bei dem mindestens ein siliciumhaltiges Polymer aus der Gruppe von Homopolymeren, Copolymeren, Terpolymeren und deren Mischungen besteht.

7. Resist nach Anspruch 6, bei dem das Homopolymer, Copolymer oder Terpolymer aus Polymermaterialien der Gruppe von Poly(methylphenyl-siloxanen), Poly(tetramethyl-p-silphenylen-siloxanen), Polydimethylsiloxansilphenylen-Copolymeren, Polydimethylsiloxan-alphamethylstyrol-Copolymeren, Bisphenol-A-polycarbonatpolydimethylsiloxan-Blockcopolymeren, Polydimethylsiloxan-styrol-Blockcopolymeren, Hexamethylterephthalatsiloxan-Blockcopolymeren und Polyurethan-siloxan-Blockcopolymeren besteht.

8. Resist nach Anspruch 6, bei dem das siliciumhaltige Copolymer ein Blockcopolymer ist, das siliciumhaltige Segmente der Gruppe von Polysilphenylensiloxan, Polydialkylsiloxanen, Polysilarylensiloxanen und Dimethylsiloxan kombiniert mit nichtsiliciumhaltigen Segmenten der Gruppe von Bisphenol-A-polycarbonat, Polyurethan, Polyester, Polyimid, Polyharnstoff, Poly(alkylenether) und Polysulfon enthält.

9. Resist nach den Ansprüchen 1 und 8 bestehend aus der Mischung von Bisphenol-A-polycarbonatpolydimethylsiloxan-Blockcopolymer mit Poly(methylpenten-methallyl-ethylether-sulfon).

10. Resist nach den Ansprüchen 1 und 8, das aus einer Mischung von Polydimethylsiloxan-alpha-methylstyrol-Blockcopolymer mit Poly(methylpenten-methallyl-ethylether-sulfon) besteht.

11. Lithographisches Verfahren mit folgenden Schritten:
Aufbringen der Resistzusammensetzungen nach einem oder mehreren der Ansprüche 1 bis 10 auf einem Substrat;

Härten des Resists;

bildmäßiges Belichten durch Bestrahlung und

Entwickeln, so daß nach Entfernen der belichteten und unbelichteten Bildteile des Resists ein Resistmuster vorhanden ist.

12. Verfahren nach Anspruch 11, bei dem im Anschluß an das bildmäßige Belichten durch Bestrahlung der belichtete Resist bei einer Temperatur von ca. 85 bis ca. 115° C für ca. 20 bis ca. 40 Minuten, vorzugsweise bei ca. 80° C bis ca. 110° C für ca. 10 bis ca. 30 Minuten, nachgehärtet wird.

13. Verfahren nach Anspruch 11, bei dem das bildmäßige Belichten mit ferner UV-Strahlung mit einer Wellenlänge von ca. 200 bis 300 nm erfolgt.

14. Verfahren nach Anspruch 11, bei dem das bildmäßige Belichten durch Röntgenstrahlung mit einer durchschnittlichen Belichtungsdosis von ca. 10 bis ca. 50 Millijoule/cm² zur Erzielung positiver Resisteigenschaften oder mit einer durchschnittlichen Belichtungsdosis von ca. 120 bis ca. 200 Millijoule/cm² zur Erzielung negativer Resisteigenschaften erfolgt.

15. Verfahren nach Anspruch 11, bei dem das bildmäßige Belichten durch Elektronenstrahlung mit einer durchschnittlichen Belichtungsdosis von ca. 1,0 bis ca. 5,0 Mikrocoulomb/cm² zur Erzielung positiver Resisteigenschaften oder mit einer durchschnittlichen Belichtungsdosis von ca. 10,0 Mikrocoulomb/cm² bis ca. 15,0 Mikrocoulomb/cm² zur Erzielung negativer Resisteigenschaften erfolgt.

16. Lithographisches Verfahren nach Anspruch 11, bei dem das Resistmuster durch Ätzen, vorzugsweise durch Plasma- oder reaktives Ionenätzen, in eine polymere Unterschicht übertragen wird.

17. Lithographisches Verfahren nach Anspruch 16, bei dem nach vollständigem Entfernen der belichteten Bildteile des Resists ein weiteres Metall aufgetragen wird und besagtes Metall mit dem darunterliegenden Polymer von den unbelichteten Bereichen, in denen sich Resist befindet, durch ein Lösungsmittelabhebeverfahren entfernt wird.

18. Lithographisches Verfahren, in dem die Resistzusammensetzungen nach einem der Ansprüche 1 bis 10 als Film auf ein Substrat aufgetragen werden, dem sich folgende Schritte anschließen:

Vorhärten, bildmäßiges Belichten durch einen Excimerlaser mit ferner UV-Strahlung sowie Lösungsmittel- oder Trockenentwicklung zur vollständigen Entfernung der belichteten Bildteile des Resists.


**Revendications**

1. Réserve lithographique, caractérisée en ce qu'elle comprend un mélange d'au moins une polysulfone sensible aux radiations avec au moins un polymère contenant du silicium.

2. Réserve suivant la revendication 1, caractérisée en ce que la polysulfone est un copolymère formé par la polymérisation du dioxyde de soufre avec une matière choisie dans le groupe comprenant des 1-oléfines à chaîne droite, des 1-oléfines à chaîne ramifiée, des 2-oléfines, des oléfines cycliques et des composés allyliques.

3. Réserve suivant la revendication 2, caractérisée en ce que le copolymère polysulfonique est choisi dans le groupe comprenant une poly(2-méthylpentène-1-sulfone), une poly(butène-1-sulfone), une poly(hexène-1-sulfone), une poly(cyclopentène-sulfone) et leurs mélanges.

4. Réserve suivant la revendication 1, caractérisée en ce que la polysulfone est un terpolymère formé par la polymérisation du dioxyde de soufre, d'un hydrocarbure oléfinique et d'un éther insaturé.

5. Réserve suivant la revendication 4, caractérisée en ce que la polysulfone est une poly(méthylpentène-méthallyl éthyl éther-sulfone).

6. Réserve suivant la revendication 1, caractérisée en ce que le polymère contenant du silicium au moins présent est choisi dans le groupe comprenant des homopolymères, des copolymères, des terpolymères et leurs mélanges.

7. Réserve suivant la revendication 6, caractérisée en ce que l'homopolymère, le copolymère ou le terpolymère est composé de matières polymères choisies dans le groupe consistant en poly(méthylphényl siloxanes), poly(tétraméthyl-p-silphénylène siloxanes), copolymères de polydiméthylsiloxane-silphénylène, copolymères de polydiméthylsiloxane-alpha-méthylstyrène, copolymères à blocs de bisphénol A-polycarbonate-polydiméthylsiloxane, copolymères à blocs de polydiméthylsiloxane-styrène, copolymères à blocs d'hexaméthyltérephtalate-siloxane et copolymères à blocs de polyuréthanne-siloxane.

8. Réserve suivant la revendication 6, caractérisée en ce que le copolymère contenant du silicium est un copolymère à blocs comprenant des segments contenant du silicium, choisis dans le groupe consistant en polysilphénylènesiloxane, polydialkylsiloxanes, polysilarylènesiloxanes et diméthylsiloxane, combinés avec des segments ne contenant pas de silicium choisis dans le groupe consistant en bisphénol A-polycarbonate, polyuréthanne, polyester, polyimide, polyurée, poly(alkylène éther) et polysulfone.

9. Réserve suivant les revendications 1 et 8, caractérisée en ce qu'elle comprend un mélange de copolymère à blocs de bisphénol A-polycarbonate-polydiméthylsiloxane avec un poly(méthylpentène méthylallyl éthyl éther-sulfone).

10. Réserve suivant les revendications 1 et 8, caractérisée en ce qu'elle comprend un mélange de copolymère à blocs de polydiméthylsiloxane-alpha-méthylstyrène avec un poly(méthylpentène-méthallyl éthyl éther-sulfone).

11. Procédé lithographique, caractérisé en ce qu'il comprend l'enduction des compositions de réserve suivant l'une ou plusieurs des revendications 1 à 10 sur un substrat, la cuisson de la réserve, l'exposition selon une image à une radiation et le développement pour éliminer des portions d'image exposées ou non exposées de la réserve pour fournir ainsi un motif de réserve.

12. Procédé suivant la revendication 11, caractérisé en ce qu'après l'exposition selon une image à une radiation, la réserve exposée est soumise à une post-cuisson à une température d'environ 85°C à 115°C pendant d'environ 20 à 40 minutes, de préférence d'environ 80° et 110°C pendant environ 10 à 30 minutes.

13. Procédé suivant la revendication 11, caractérisé en ce que l'exposition selon une image est effectuée avec une radiation ultraviolette lointaine à une longueur d'onde d'environ 200 à 300 nm.

14. Procédé suivant la revendication 11, caractérisé en ce que l'exposition selon une image est effectuée avec une irradiation par des rayons X avec une dose d'exposition moyenne d'environ 10 à environ 50 millijoules par $cm^2$ pour des caractéristiques de réserves positives, ou avec une dose d'exposition moyenne d'environ 120 à environ 200 millijoules par $cm^2$ pour des caractéristiques de réserves négatives.

15. Procédé suivant la revendication 11, caractérisé en ce que l'exposition selon une image est effectuée avec une irradiation par un faisceau électronique avec une dose d'exposition moyenne d'environ 1,0 à environ 5,0 microcoulombs par $cm^2$ pour des caractéristiques de réserves positives, ou avec une dose d'exposition moyenne d'environ 10,0 à environ 15,0 microcoulombs par $cm^2$ pour des caractéristiques de réserves négatives.

16. Procédé lithographique suivant la revendication 11, caractérisé en ce qu'il comprend de plus le transfert du motif de réserve par attaque, de préférence par attaque par plasma ou par ion réactif, dans une sous-couche polymère.

17. Procédé lithographique suivant la revendication 16, caractérisé en ce qu'un métal est de plus déposé après élimination complète des portions d'image exposées de la réserve et que ce métal avec le polymère sous-jacent est éliminé dans les zones non exposées où la réserve est présente par une procédure d'enlèvement par solvant.

18. Procédé lithographique, caractérisé en ce qu'il comprend le dépôt des compositions de réserve suivant l'une ou plusieurs des revendications 1 à 10 sur un substrat, suivi d'une précuisson, d'une exposition selon une image à un laser à excimère à une radiation UV lointaine et d'un développement par solvant ou à sec pour éliminer complètement les portions d'image exposées de la réserve.